# FASCICULE DE BREVET EUROPEEN

(11) **EP 2 804 255 B1**
(45) Date de publication et mention de la délivrance du brevet: **27.04.2016**
(21) Numéro de dépôt: 14168483.7
(22) Date de dépôt: 15.05.2014
(51) Int. Cl.: H01Q 1/08, H01Q 1/14, H01Q 1/22, G08B 1/00, H01R 12/71, H05K 3/32, H01R 13/24

(54) **Dispositif électronique muni d'une antenne radio**
Elektronische Vorrichtung mit einer Funkantenne
Electronic device provided with a radio antenna

(30) Priorité: 17.05.2013 FR 1354459
(43) Date de publication de la demande: 19.11.2014
(73) Titulaire: Hager Security, 38920 Crolles (FR)
(72) Inventeur: Dromard, Jean-Claude, 38530 CHAPAREILLAN (FR); Dumas, Didier, 38650 SAINT MICHEL LES PORTES (FR)
(74) Mandataire: Nuss, Laurent

(56) Documents cités:
- EP-A1- 1 635 419
- EP-A1- 1 961 910
- US-A1- 2003 117 338
- US-A1- 2009 251 373

## Description

La présente invention concerne le domaine des dispositifs électroniques munis d'une antenne radio ou électromagnétique, en particulier le domaine des dispositifs électroniques d'alarme tels que ceux munis de détecteurs de danger en vue de la protection des personnes et des biens, que l'on installe dans les espaces domestiques, commerciaux ou industriels afin d'avertir les occupants de l'existence d'un danger.

Actuellement, les antennes, qui sont généralement incluses dans des boîtiers, sont composées de fils métalliques souples ou rigides qui sont soudés aux circuits électroniques. De telles dispositions nécessitent des opérations de positionnement des antennes par rapport aux circuits électroniques, puis des opérations de soudage. En outre, lors du montage des circuits électroniques dans les boîtiers, l'antenne constitue une gêne et doit être installée avec précaution.

Le brevet EP 1 635 419 décrit une antenne filaire en une matière élastique qui présente une portion d'extrémité sous la forme d'une tête d'épingle apte à être engagée dans un trou d'une pièce réceptrice métallique.

Le brevet EP 1 961 910 décrit un système domotique comprenant une antenne soudée à un circuit imprimé à l'aide d'un picot.

La présente invention a pour but de faciliter et d'assurer le montage des antennes dans les dispositifs électroniques.

Il est proposé un dispositif électronique qui comprend un boîtier dans lequel sont disposées une carte électronique présentant un passage traversant et une antenne comprenant un fil métallique en une matière élastique présentant une partie d'extrémité qui comprend une portion terminale et une portion en vis-à-vis, reliées par une portion coudée, et qui est engagée au moins partiellement dans ou au travers du passage de la carte électronique.

Le boîtier et l'antenne comprennent des parties ou portions d'appui réciproque telles que, sous l'effet de l'élasticité du fil métallique, la partie d'extrémité de l'antenne prend appui sur au moins une zone de la carte électronique munie d'un contact électrique afin d'établir une liaison électrique entre l'antenne et ce contact électrique.

En outre, le boîtier comprend un doigt en saillie qui présente une tête de positionnement et de maintien engagée entre ladite portion terminale et ladite portion en vis-à-vis de ladite partie d'extrémité de l'antenne et coopérant avec cette partie d'extrémité pour assurer l'appui de cette dernière sur ledit contact électrique.

Ladite portion terminale et ladite portion en vis-à-vis peuvent prendre appui sur des zones opposées dudit passage de la carte électronique dont au moins l'une est munie dudit contact électrique.

Le boîtier peut comprendre des moyens de positionnement et de maintien de l'antenne par conjugaison de formes.

Le doigt en saillie peut être en appui sur ladite partie d'extrémité de l'antenne au moins au-delà de l'une desdites zones opposées dudit passage de la carte électronique.

Le doigt en saillie peut présenter une fente latérale de retenue dans laquelle est introduite la portion coudée de la partie d'extrémité de l'antenne.

Le doigt en saillie peut présenter des flancs opposés situés respectivement du côté de ladite portion terminale et de ladite portion en vis-à-vis de ladite partie d'extrémité de l'antenne, un espace subsistant entre au moins l'un desdits flancs et la portion correspondante de l'antenne.

Ladite antenne peut comprendre une partie d'appui sur le support relié à sa partie d'extrémité par une partie déformée produisant un effet de ressort comprimé.

Ladite antenne peut présenter une portion allongée reliée à sa partie d'extrémité, introduite dans au moins une fente de maintien du support.

Le support peut comprendre une embase et un couvercle pouvant être accouplés, délimitant une chambre dans laquelle la carte électronique est installée, l'un d'entre eux étant muni de l'antenne.

Des dispositifs électroniques vont maintenant être décrits à titre d'exemples non limitatifs, illustrés par le dessin annexé sur lequel :
- la figure 1 représente une coupe partielle d'un dispositif électronique selon un premier plan, dans une position accouplée ;
- la figure 2 représente une coupe partielle du dispositif électronique de la figure 1, selon un second plan perpendiculaire audit premier plan ;
- la figure 3 représente une coupe partielle du dispositif électronique de la figure 1, selon ledit premier plan, dans une position désaccouplée ;
- la figure 4 représente une coupe partielle du dispositif électronique de la figure 1, selon ledit second plan, dans une position désaccouplée ;
- la figure 5 représente une vue en perspective d'une antenne du dispositif électronique précité ;
- la figure 6 représente une coupe partielle agrandie d'un détail du montage d'une antenne sur un doigt du dispositif électronique précité ;
- la figure 7 représente une vue en perspective du côté intérieur d'un couvercle du dispositif électronique précité, équipé d'une antenne ; et
- la figure 8 représente une coupe partielle agrandie d'une variante de réalisation du montage d'une antenne sur un doigt du dispositif électronique précité.

Un dispositif électronique 1 comprend un boîtier 2, par exemple en une matière plastique, composé d'une embase 3 et d'un couvercle 4 qui peuvent être accouplés l'un au-dessus de l'autre par tous moyens d'accouplement appropriés (non représentés), par exemple par encliquetage, et qui, en position accouplée, délimitent entre eux une chambre 5.

Dans la chambre 5 est installée une carte électronique 6, maintenue en position par exemple par conjugaison de formes.

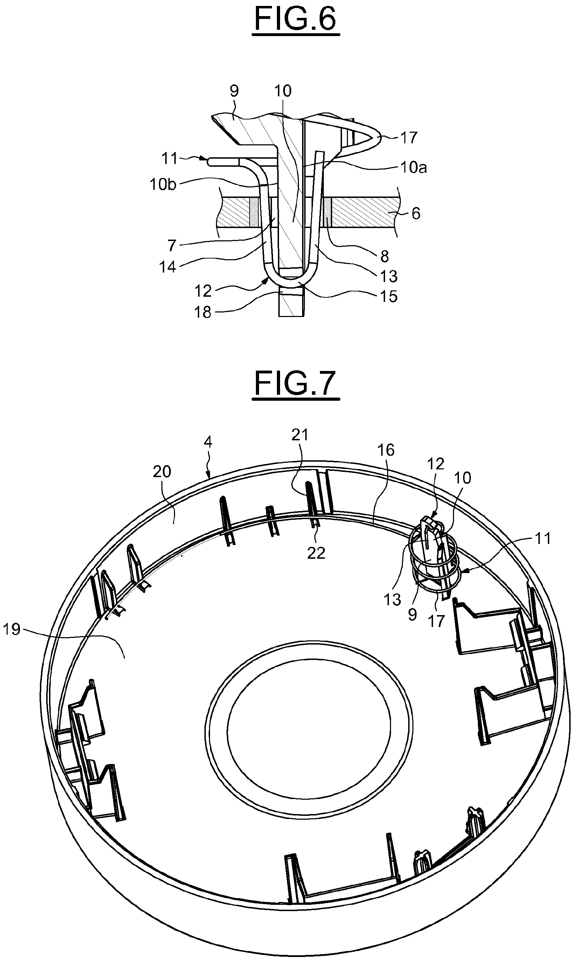

La carte électronique 6 présente, en un endroit, un passage traversant 7 recouvert d'une couche 8 en une matière conductrice de l'électricité (figure 6), qui forme un contact électrique et qui est relié au circuit électronique (non représenté) de la carte électronique 6.

Le couvercle 4 comprend un doigt 9 en saillie dans la chambre 5, qui présente une partie d'extrémité ou tête 10 qui peut être engagée librement, avec un jeu, au travers du passage traversant 7 de la carte électronique 6 lorsque l'embase 3 et le couvercle 4 sont accouplés.

Le couvercle 4 est muni d'une antenne radio ou électromagnétique 11 formée par un fil métallique en une matière élastique et conformée par pliage, par exemple de la manière suivante.

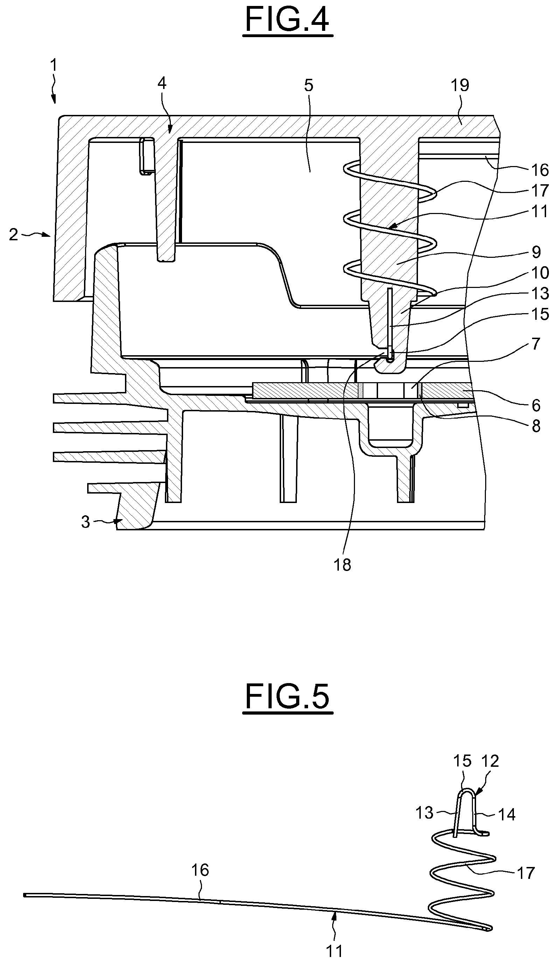

Comme illustré en particulier sur la figure 5, l'antenne préformée 11 comprend une partie d'extrémité 12 qui comprend une portion terminale 13 et une portion en vis-à-vis 14, par exemple rectilignes et reliées par une portion coudée 15 en formant un V, et comprend une portion allongée 16 reliée à la portion en vis-à-vis 14 par une portion 17 se présentant sous la forme d'une spirale. La portion allongée 16 s'étend perpendiculairement ou dans un plan perpendiculaire à l'axe de la portion en spirale 17 et le V formé par la portion terminale 13 et la portion en vis-à-vis 14 est ouvert du côté de la portion en spirale 17.

La longueur de l'antenne 11, c'est-à-dire principalement la longueur de la portion allongée 16 et de la portion en spirale 17, est adaptée à la fréquence de résonnance ou aux fréquences de résonnance souhaitées.

L'antenne 11 est montée sur le couvercle 4 par conjugaison de formes, c'est-à-dire sans élément complémentaire de fixation, de la manière suivante.

La portion en spirale 17 est disposée librement autour du doigt en saillie 9.

Comme illustré en particulier sur la figure 6, la partie d'extrémité 12 est montée à cheval sur la tête 10 du doigt en saillie 9, dans le sens de l'axe de ce dernier, de telle sorte que la tête 10 est engagée dans le V formé entre la portion terminale 13 et la portion en vis-à-vis 14.

La tête 10 du doigt en saillie 9 présente une fente latérale de retenue 18 dans laquelle est engagée la portion coudée 15 de l'antenne 11, les flancs opposés de la fente de retenue 18 formant des épaulements de telle sorte que l'antenne 11 est maintenue dans les deux sens selon l'axe de la portion en spirale 17.

La tête 10 du doigt en saillie 9 présente des flancs opposés parallèles 10a et 10b devant lesquels la portion terminale 13 et la portion en vis-à-vis 14 s'étendent en ménageant des espaces.

Comme illustré en particulier sur la figure 7, la portion allongée 16 s'étend au-dessus d'une paroi 19 du couvercle 4, parallèle à la carte électronique 6, en longeant une paroi cylindrique 20, la partie allongée 16 étant arquée en correspondance.

Le couvercle 4 comprend des parties en saillie 21, espacées, présentant des fentes de maintien 22 dans lesquelles est engagée, latéralement, la portion allongée 16 de l'antenne 11, une fente de maintien étant prévue au pied du doigt en saillie 9.

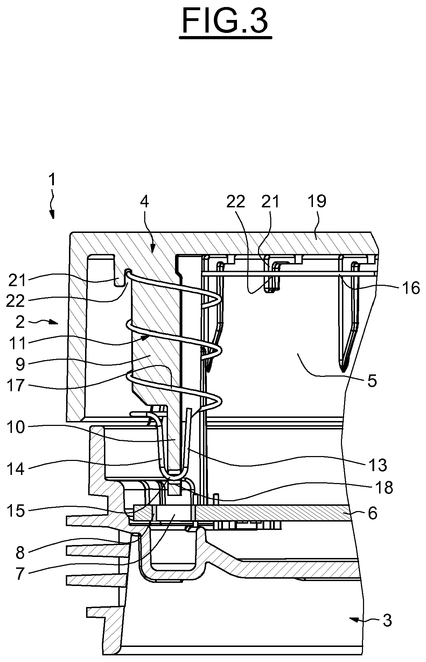

Comme illustré en particulier sur les figures 3, 4 et 7, pour monter l'antenne 11 sur le couvercle 4, séparé de l'embase 3, il suffit donc de placer la portion en spirale 17 autour du doigt en saillie 9, puis, dans cet ordre ou dans l'autre, d'engager la portion coudée 15 dans la fente de retenue 18 de la tête 10 du doigt en saillie 9 en déformant la partie d'extrémité 12 et d'engager la portion allongée 16 dans les fentes de maintien 22 du couvercle 4, en utilisant l'élasticité du fil métallique.

Ensuite, lorsque l'on approche et que l'on amène l'embase 3 et le couvercle 4 jusqu'à leur position accouplée, la partie d'extrémité 12 de l'antenne 11 s'engage, la pointe du V en premier, au travers du passage 7 de la carte électronique 6, avec la tête 10 du doigt en saillie 9 qui l'entraîne dans le sens de l'introduction du fait que le flanc de la fente de retenue 18 situé du côté de la portion en spirale la tête 10 du doigt en saillie 9 et la portion coudée 15 de la partie d'extrémité 12 sont en appui réciproque. Le doigt en saillie 9 assure le positionnement correct de la partie d'extrémité 12 de l'antenne 11 par rapport au passage 7 de la carte électronique 6.

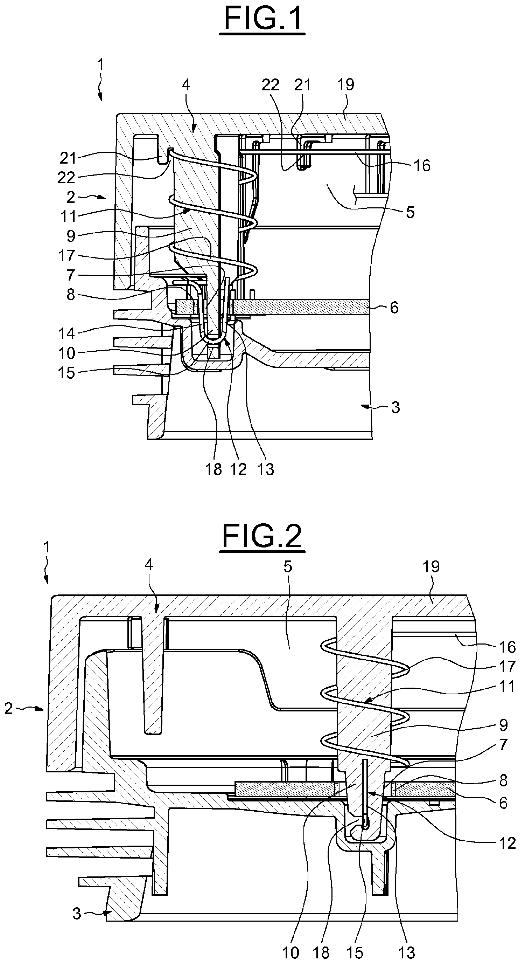

Ce faisant, comme illustré sur les figures 1, 2 et 6, la portion terminale 13 et la portion en vis-à-vis 14 de la partie d'extrémité 12 de l'antenne 11 viennent en appui sur des zones opposées de la couche conductrice 8. L'appui de la portion coudée 15 sur la tête 10 du doigt en saillie 9 étant au-delà de ces zones, la portion terminale 13 et la portion en vis-à-vis 14 glissent sur ces zones, en réduisant l'angle d'ouverture du V que les portions 13 et 14 forment, à l'encontre de l'élasticité du fil métallique formant l'antenne 11 et en bénéficiant de la flexibilité des portions 13 et 14. En fin de course, la portion terminale 13 et la portion en vis-à-vis 14 sont à faibles distances des flancs 10a et 10b de la tête 10 du doigt en saillie 9 qui produit un effet de coincement.

Ainsi, lorsque l'embase 3 et le couvercle 4 sont à leur position accouplée, la portion terminale 13 et la portion en vis-à-vis 14 de la partie d'extrémité 12 de l'antenne 11 sont fermement maintenues en appui sur la couche conductrice 8 et une liaison électrique sécurisée est établie entre l'antenne 11 et le contact électrique formé par cette couche conductrice 8.

Lorsque l'embase 3 et le couvercle 4 sont séparés, il se produit un mouvement et un effet inverses, la portion coudée 15 de la partie d'extrémité 12 de l'antenne 11 venant en appui sur l'épaulement formé par le flanc de la fente de retenue 18 situé à l'opposé de la portion en spirale 17 de telle sorte que la partie d'extrémité 12 de l'antenne 11 est entraînée dans le sens de son extraction en dehors du passage 7 de la carte électronique.

Selon une variante de réalisation, la portion en spirale 17 de l'antenne 11 pourrait être remplacée par une portion droite ou arquée.

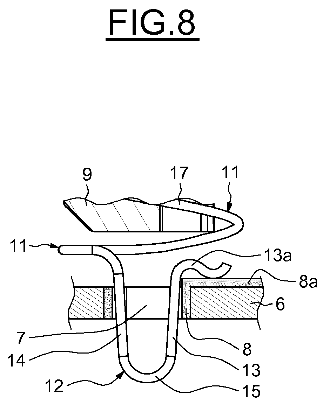

Selon une variante de réalisation illustrée sur la figure 8, la tête 10 du doigt en saillie 9 pourrait être supprimée. Dans ce cas, l'élasticité du fil formant l'antenne 11 devrait être telle que la portion en spirale 15 ou la portion légèrement arquée pouvant la remplacer produisent un effet de ressort comprimé assurant l'appui de la portion terminale 13 et la portion en vis-à-vis 14 de la partie d'extrémité 12 de l'antenne 11 sur la couche conductrice 8 formant un contact électrique.

Selon une variante de réalisation également illustrée sur la figure 8, la partie d'extrémité 12 de l'antenne 11 pourrait présenter une ou des portions coudées venant en appui sur un contact électrique 8a de la face de la carte électronique 6 tournée du côté du couvercle 4, par exemple une portion coudée 13a formée à l'extrémité de la portion terminale 13.

Selon une variante de réalisation, l'antenne 11 pourrait être portée par l'embase 3 de façon équivalente à son montage sur le couvercle 4.

La présente invention ne se limite pas aux exemples ci-dessus décrits. Bien d'autres variantes de réalisation sont possibles sans sortir du cadre de l'invention.

## Revendications

1. Dispositif électronique comprenant un boîtier (2) dans lequel sont disposées une carte électronique (6) présentant un passage traversant (7) et une antenne (11) comprenant un fil métallique en une matière élastique présentant une partie d'extrémité (12) qui comprend une portion terminale (13) et une portion en vis-à-vis (14), reliées par une portion coudée (15), et qui est engagée au moins partiellement dans ou au travers du passage de la carte électronique,
dans lequel le boîtier (2) et l'antenne (11) comprennent des parties ou portions d'appui réciproque telles que, sous l'effet de l'élasticité du fil métallique, la partie d'extrémité de l'antenne prend appui sur au moins une zone de la carte électronique munie d'un contact électrique (8, 8a) afin d'établir une liaison électrique entre l'antenne et ce contact électrique,
et dans lequel le boîtier (2) comprend un doigt en saillie (9) qui présente une tête (10) de positionnement et de maintien (3, 4 et 51) engagée entre ladite portion terminale (13) et ladite portion en vis-à-vis (14) de ladite partie d'extrémité (12) de l'antenne et coopérant avec cette partie d'extrémité (12) pour assurer l'appui de cette dernière sur ledit contact électrique (8).

2. Dispositif selon la revendication 1, dans lequel ladite portion terminale et ladite portion en vis-à-vis prennent appui sur des zones opposées dudit passage de la carte électronique dont au moins l'une est munie dudit contact électrique.

3. Dispositif selon l'une des revendications 1 et 2, dans lequel le boîtier (2) comprend des moyens de positionnement et de maintien de l'antenne par conjugaison de formes (21).

4. Dispositif selon l'une quelconque des revendications précédentes, dans lequel le doigt en saillie est en appui sur ladite partie d'extrémité de l'antenne au moins au-delà de l'une desdites zones opposées dudit passage de la carte électronique.

5. Dispositif selon l'une quelconque des revendications précédentes, dans lequel le doigt en saillie présente une fente latérale de retenue (18) dans laquelle est introduite la portion coudée (15) de la partie d'extrémité de l'antenne.

6. Dispositif selon l'une quelconque des revendications précédentes, dans lequel le doigt en saillie présente des flancs opposés (10a, 10b) situés respectivement du côté de ladite portion terminale (13) et de ladite portion en vis-à-vis (14) de ladite partie d'extrémité de l'antenne, un espace subsistant entre au moins l'un desdits flancs et la portion correspondante de l'antenne.

7. Dispositif selon l'une quelconque des revendications précédentes, dans lequel ladite antenne comprend une partie d'appui (16) sur le support relié à sa partie d'extrémité (12) par une partie déformée (17) produisant un effet de ressort comprimé.

8. Dispositif selon l'une quelconque des revendications précédentes, dans lequel l'antenne présente une portion allongée (16) reliée à sa partie d'extrémité, introduite dans au moins une fente de maintien (22) du support.

9. Dispositif selon l'une quelconque des revendications précédentes, dans lequel le support comprend une embase (3) et un couvercle (4) pouvant être accouplés, délimitant une chambre (5) dans laquelle la carte électronique (6) est installée, l'un d'entre eux étant muni de l'antenne (11).

## Patentansprüche

1. Elektronische Vorrichtung, die ein Gehäuse (2) umfasst, in dem eine Elektronikkarte (6), die einen Durchgang (7) und eine Antenne (11) aufweist, die einen metallischen Draht aus einem elastischen Werkstoff aufweist, der einen Endteil (12) aufweist, der einen Anschlussabschnitt (13) und einen Abschnitt (14) in Gegenüberlage umfasst, die durch einen abgewinkelten Abschnitt (15) verbunden sind, und der mindestens teilweise in oder durch den Kanal der Elektronikkarte eingefügt ist,
wobei das Gehäuse (2) und die Antenne (11) Teile oder Abschnitte zum gegenseitigen Aufliegen derart aufweisen, dass unter der Einwirkung der Elastizität des metallischen Drahts der Endteil der Antenne auf mindestens einer Zone der Elektronikkarte, die mit einem elektrischen Kontakt (8, 8a) versehen ist, um eine elektrische Verbindung zwischen der Antenne und diesem elektrischen Kontakt herzustellen, aufliegt,
und wobei das Gehäuse (2) einen vorstehenden Finger (9) umfasst, der einen Kopf (10) zum Positionieren und Halten (3, 4 und 51) aufweist, der zwischen dem Anschlussabschnitt (13) und dem Abschnitt in Gegenüberlage (14) des Endteils (12) der Antenne eingefügt ist und mit diesem Endteil (12) zusammenwirkt, um das Aufliegen dieses Letzteren auf dem elektrischen Kontakt (8) sicherzustellen.

2. Vorrichtung nach Anspruch 1, wobei der Anschlussabschnitt und der Abschnitt in Gegenüberlage auf gegenüberliegenden Zonen des Durchgangs der Elektronikkarte, von welchen mindestens eine mit dem elektrischen Kontakt versehen ist, aufliegen.

3. Vorrichtung nach einem der Ansprüche 1 und 2, wobei das Gehäuse (2) Mittel zum Positionieren und Halten der Antenne durch Formschluss (21) umfasst.

4. Vorrichtung nach einem der vorhergehenden Ansprüche, wobei der vorstehende Finger auf dem Endteil der Antenne mindestens über eine der gegenüberliegenden Zonen des Durchgangs der Elektronikkarte in Auflage ist.

5. Vorrichtung nach einem der vorhergehenden Ansprüche, wobei der vorstehende Finger einen seitlichen Halteschlitz (18) aufweist, in den der abgewinkelte Abschnitt (15) des Endteils der Antenne eingefügt ist.

6. Vorrichtung nach einem der vorhergehenden Ansprüche, wobei der vorstehende Finger gegenüberliegende Flanken (10a, 10b) aufweist, die jeweils auf der Seite des Anschlussabschnitts (13) und des Abschnitts in Gegenüberlage (14) des Endteils der Antenne liegen, wobei ein Raum zwischen mindestens einer der Flanken und dem entsprechenden Abschnitt der Antenne verbleibt.

7. Vorrichtung nach einem der vorhergehenden Ansprüche, wobei die Antenne einen Trägerteil (16) auf dem Träger, der mit ihrem Endteil (12) durch einen verformten Teil (17), der eine Wirkung einer Druckfeder erzeugt, verbunden ist, umfasst.

8. Vorrichtung nach einem der vorhergehenden Ansprüche, wobei die Antenne einen verlängerten Abschnitt (16) aufweist, der mit dem Endteil, das in mindestens einen Halteschlitz (22) des Trägers eingefügt ist, verbunden ist.

9. Vorrichtung nach einem der vorhergehenden Ansprüche, wobei der Träger einen Sockel (3) und einen Deckel (4), die gekoppelt werden können, umfasst, der eine Kammer (5) abgrenzt, in der die Elektronikkarte (6) installiert ist, wobei einer von ihnen mit der Antenne (11) versehen ist.

## Claims

1. Electronic device comprising a housing (2) in which are arranged an electronic card (6) having a through passage (7) and an antenna (11) comprising a metal wire made of an elastic material having an end portion (12) that comprises a terminal portion (13) and an opposing portion (14) connected by a bent portion (15), and that is engaged at least partially in or through the passage of the circuit board,
the housing (2) and the antenna (11) comprising parts or portions of reciprocal support such that, under the effect of the elasticity of the metal wire, the end portion of the antenna is supported on at least one area of the circuit board provided with an electrical contact (8, 8a) to establish an electrical connection between the antenna and the said electrical contact,
and in which the housing (2) includes a protruding finger (9) that has a head (10) for positioning and retaining (3, 4 and 51) engaged between the said terminal portion (13) and the said opposing portion (14) of the said end portion (12) of the antenna and cooperating with the said end portion (12) to provide support for the latter on the said electrical contact (8).

2. Device according to claim 1, in which the said terminal portion and the said opposing portion are supported on opposite areas of the said passage of the electronic card, at least one of which is provided with the said electrical contact.

3. Device according to one of claims 1 and 2, in which the housing (2) comprises means for positioning and retaining the antenna by positive locking (21).

4. Device according to any one of the preceding claims, in which the protruding finger is supported on the said end portion of the antenna at least beyond one of the said opposite areas of the said passage of the electronic card.

5. Device according to any of the preceding claims, in which the protruding finger has a lateral retaining slot (18) into which is introduced the bent portion (15) of the end portion of the antenna.

6. Device according to any one of the preceding claims, in which the protruding finger has opposite sides (10a, 10b) situated respectively on the side of the said terminal portion (13) and on the side of the said opposing portion (14) of the said end portion of the antenna, there being a space between at least one of the said sides and the corresponding portion of the antenna.

7. Device according to any one of the preceding claims, in which the said antenna comprises a supporting portion (16) on the support connected to its end portion (12) by a deformed portion (17) producing a compressed spring effect.

8. Device according to any one of the preceding claims, in which the antenna has an elongated portion (16) connected to its end portion, introduced into at least one retaining slot (22) of the support.

9. Device according to any one of the preceding claims, in which the support comprises a base (3) and a cover (4) capable of being coupled together, delimiting a chamber (5) in which the electronic card (6) is installed, one of them being fitted with the antenna (11).
